# EUROPEAN PATENT APPLICATION

(11) **EP 4 345 809 A2**
(43) Date of publication of application: **03.04.2024**
(21) Application number: 24150369.7
(22) Date of filing: 23.05.2018
(51) Int. Cl.: G09G 3/3266

(54) **ORGANIC ELECTROLUMINESCENCE DISPLAY PANEL, FABRICATING METHOD THEREOF, AND DISPLAY DEVICE**

(30) Priority: 29.06.2017 CN 201710516966
(62) Divisional of application: 18825345.4
(71) Applicant: BOE Technology Group Co., Ltd., Chaoyang District, Beijing 100015 (CN); Chengdu BOE Optoelectronics Technology Co., Ltd., Chengdu, Sichuan 611731 (CN)
(72) Inventor: KO, Youngyik, Beijing, 100176 (CN); TAN, Wen, Beijing, 100176 (CN); HUANG, Weiyun, Beijing, 100176 (CN); WANG, Benlian, Beijing, 100176 (CN)
(74) Representative: Gesthuysen Patentanwälte

(57) **Abstract**

The present disclosure relates to a display panel and a display device. The display panel comprises a base substrate comprising a display area; a plurality of pixel driving circuits, a plurality of light-emitting units and a plurality of connection lines, the plurality of pixel driving circuits, the plurality of light-emitting units and the plurality of connection lines being located on the base substrate and in the display area. At least one pixel driving circuit of the plurality of pixel driving circuits is electrically connected with at least one light-emitting unit of the plurality of light-emitting units via at least one connection line of the plurality of connection lines.

## Description

### RELATED APPLICATION

The present application claims the benefit of Chinese Patent Application No. 201710516966.4, filed on June 29, 2017, the entire disclosure of which is incorporated herein by reference.

### TECHNICAL FIELD

The present disclosure relates to the field of display technology, and discloses specifically an organic electroluminescence display panel, a fabricating method thereof, and a display device.

### BACKGROUND

In a conventional display panel, the display area is generally located in the middle of panel, and the gate driving circuit is located near the frame of panel. In this way, adverse effects on the display area due to the gate driving circuit are avoided. However, such an arrangement of gate driving circuit at the frame tends to result in display panels and subsequent display products with wider frames.

Therefore, with the increasing popularity of narrow frames and even frameless designs, it has been proposed to move the gate driving circuit from the frame area to the display area, for example, into the pixel area, so as to narrow down and even eliminate the frame. However, in a specific implementation, it is extremely difficult to dispose a gate driving circuit in the display. For OLED products, especially high-resolution OLED products, it is very difficult to dispose further the gate driving circuit in a limited display area, since the complicated pixel driving circuit has been disposed in the same display area.

### SUMMARY

According to an aspect of the present disclosure, an embodiment provides a display panel, which comprises: a base substrate comprising a display area; a plurality of pixel driving circuits, a plurality of light-emitting units and a plurality of connection lines, the plurality of pixel driving circuits, the plurality of light-emitting units and the plurality of connection lines being located on the base substrate and in the display area. At least one pixel driving circuit of the plurality of pixel driving circuits is electrically connected with at least one light-emitting unit of the plurality of light-emitting units via at least one connection line of the plurality of connection lines.

In some embodiments, one pixel driving circuit of the plurality of pixel driving circuits is electrically connected with at least two light-emitting units of the plurality of light-emitting units via at least two connection lines of the plurality of connection lines.

In some embodiments, the plurality of pixel driving circuits are electrically connected in one-to-one correspondence with the plurality of light-emitting units via the plurality of connection lines.

In some embodiments, the display area comprises a first display subarea and a second display subarea located on at least one side of the first display subarea, the plurality of light-emitting units comprise multiple first light-emitting units within the first display subarea, the plurality of pixel driving circuits comprise multiple first pixel driving circuits within the second display subarea, the plurality of connection lines comprise multiple first connection lines. The multiple first pixel driving circuits are electrically connected in one-to-one correspondence with the multiple first light-emitting units via the multiple first connection lines, and orthogonal projections of the multiple first pixel driving circuits on the base substrate do not overlap with orthogonal projections of the multiple first light-emitting units on the base substrate.

In some embodiments, the plurality of light-emitting units comprise multiple second light-emitting units within the second display subarea, the plurality of pixel driving circuits comprise multiple second pixel driving circuits within the second display subarea, the plurality of connection lines comprise multiple second connection lines. The multiple second pixel driving circuits are electrically connected in one-to-one correspondence with the multiple second light-emitting units via the multiple second connection lines, an orthographic projection of at least one second pixel driving circuit of the multiple second pixel driving circuits on the base substrate partially overlaps with an orthographic projection of at least one second light-emitting unit of the multiple second light-emitting units on the base substrate.

In some embodiments, the display area further comprises a third display subarea located on at least one side of the second display subarea. The plurality of light-emitting units comprise multiple third light-emitting units within the third display subarea, the plurality of pixel driving circuits comprise multiple third pixel driving circuits within the third display subarea, the plurality of connection lines comprise multiple third connection lines. The multiple third pixel driving circuits are electrically connected in one-to-one correspondence with the multiple third light-emitting units via the multiple third connection lines, an orthographic projection of at least one third light-emitting unit of the multiple third light-emitting units on the base substrate covers an orthographic projection of at least one third connection line of the multiple third connection lines on the base substrate.

In some embodiments, the plurality of connection lines are located on a side of the plurality of pixel driving circuits facing away the base substrate, and the plurality of light-emitting units are located on a side of the plurality of connection lines facing away the base substrate.

In some embodiments, each light-emitting unit of the plurality of light-emitting units comprises an anode, a light-emitting layer and a cathode sequentially stacked, wherein the anode is connected to a corresponding pixel driving circuit of the plurality of pixel driving circuits via a corresponding connection line of the plurality of connection lines.

In some embodiments, the plurality of pixel driving circuits comprise a source-drain metal layer on the base substrate, the display panel further comprise an insulating layer on the source-drain metal layer and a connection line layer on the insulating layer, wherein the connection line layer comprises the plurality of connection lines.

In some embodiments, the display panel further comprises a planarization layer, each light-emitting unit of the plurality of light-emitting units comprises an anode, a light-emitting layer and a cathode sequentially stacked, wherein the planarization layer is between the source-drain metal layer and a layer of the anode, and the connection line layer is between the insulating layer and the planarization layer.

In some embodiments, the display panel further comprises a gate driving circuit on the base substrate, the gate driving circuit comprises a first gate sub-driving circuit and a second gate sub-driving circuit, the first gate sub-driving circuit and the second gate sub-driving circuit respectively extend along a first edge and a second edge of the display area opposite to each other, wherein the first gate sub-driving circuit is located within the first display subarea.

In some embodiments, the first gate sub-driving circuit and the second gate sub-driving circuit are separated from each other by at least the second display subarea.

In some embodiments, orthogonal projections of the first gate sub-driving circuit and the second gate sub-driving circuit on the base substrate do not overlap with orthogonal projections of the plurality of pixel driving circuits on the base substrate, wherein an orthogonal projection of the first gate sub-driving circuit on the base substrate partially overlaps orthogonal projections of at least some first light-emitting units of the multiple first light-emitting units on the base substrate.

In some embodiments, the display panel further comprises a gate driving circuit on the base substrate, the gate driving circuit comprises a first gate sub-driving circuit and a second gate sub-driving circuit, wherein the first gate sub-driving circuit is located within the first display subarea and extends along an edge of the first display subarea, the second gate sub-driving circuit is between two adjacent columns of pixel driving circuits of the plurality of pixel driving circuits.

Another embodiment of the application provides a display device, the display device comprises the display panel according to any one of the foregoing embodiments.

### BRIEF DESCRIPTION OF THE DRAWINGS

Fig. 1 is a schematic structural diagram of a display panel according to a conventional approach;
Fig. 2 is a schematic diagram showing a circuit structure of a shift register in the display panel of Fig. 1;
Fig. 3 is a schematic diagram showing a circuit structure of a shift register located in a display area according to another conventional approach;
Figs. 4-6 are respectively schematic structural diagrams of organic electroluminescence display panels according to embodiments of the present disclosure; and
Fig. 7 schematically shows a simplified cross-sectional view of a hierarchical relationship between a connection line, a top emission type of light-emitting unit, and a pixel driving circuit in an organic electroluminescence display panel according to an embodiment of the present disclosure.

### DETAILED DESCRIPTION OF THE DISCLOSURE

Specific implementations of the organic electroluminescence display panel, the fabricating method thereof and the display device provided by embodiments of the present disclosure will be described in detail below with reference to the accompanying drawings.

It should be noted that the thickness and shape of various film layers in the drawings do not represent any real proportion in the organic electroluminescence display panel, and are merely intended to illustrate the present disclosure.

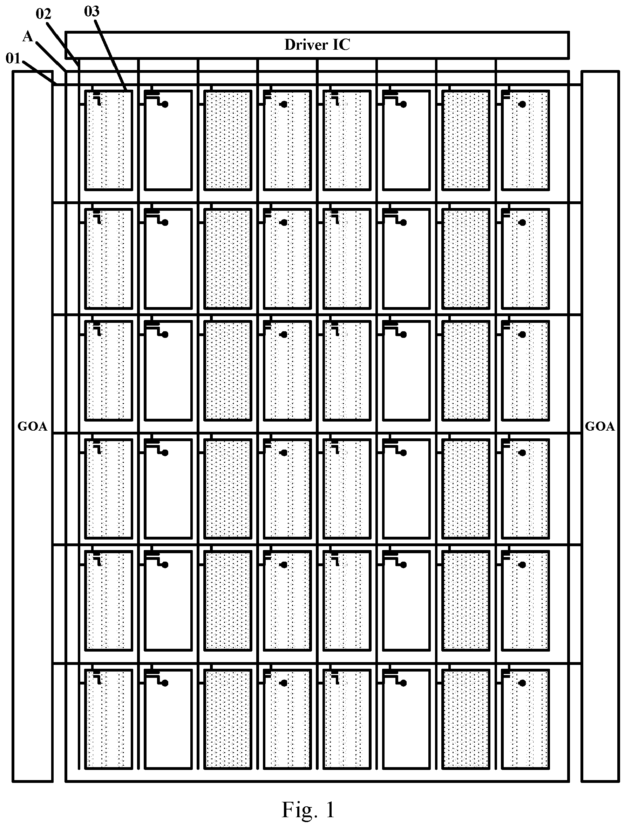

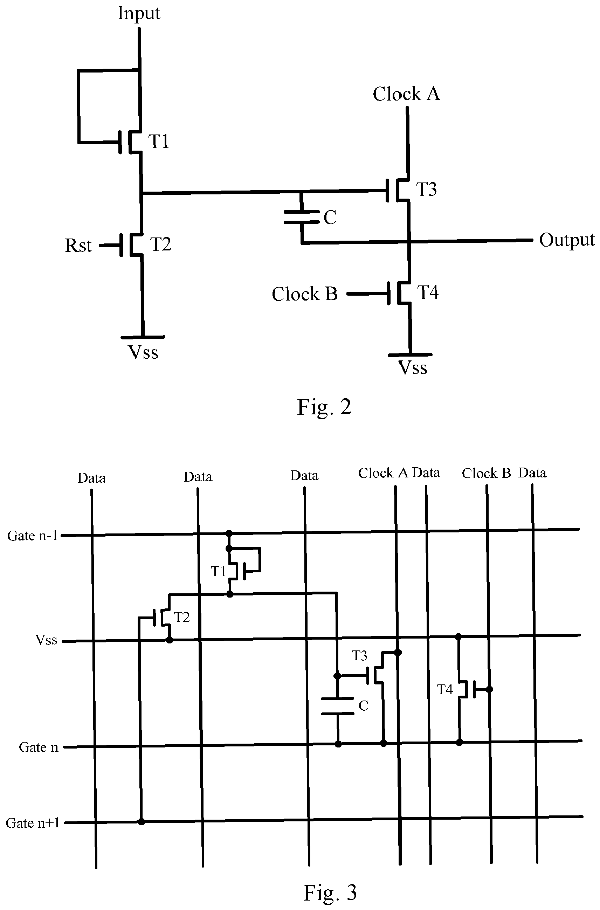

As shown in Fig. 1, according to a conventional approach, a gate line 01, a data line 02, and a pixel unit 03 are disposed in a display area A of a display panel, wherein the pixel unit is disposed in an area defined by the gate line 01 and the data line 02. Also, a gate driving circuit for driving the gate line 01 is provided at the left and right frames. Specifically, the gate driving circuit consists of a plurality of cascaded shift registers, wherein each shift register is composed of at least four switching transistors T1, T2, T3, and T4, and a circuit structure diagram thereof is shown in Fig. 2.

As mentioned above, for the purpose of narrowing down the frame of display panel and even realizing a frameless design, it has been proposed to use the approach as shown in Fig. 3, in which the gate driving circuit that was located otherwise in the frame area is moved now to the pixel area. In this way, the space for disposing the gate driving circuit at the frame is eliminated, thereby realizing an ultra-narrow frame or even a frameless design. However, in actual operations, it is difficult to dispose a gate driving circuit in the display area. In particular, for OLED products, the difficulty is further increased, because in OLED products, especially in high-resolution OLED products, complex pixel circuits have already been disposed in the size-limited display area.

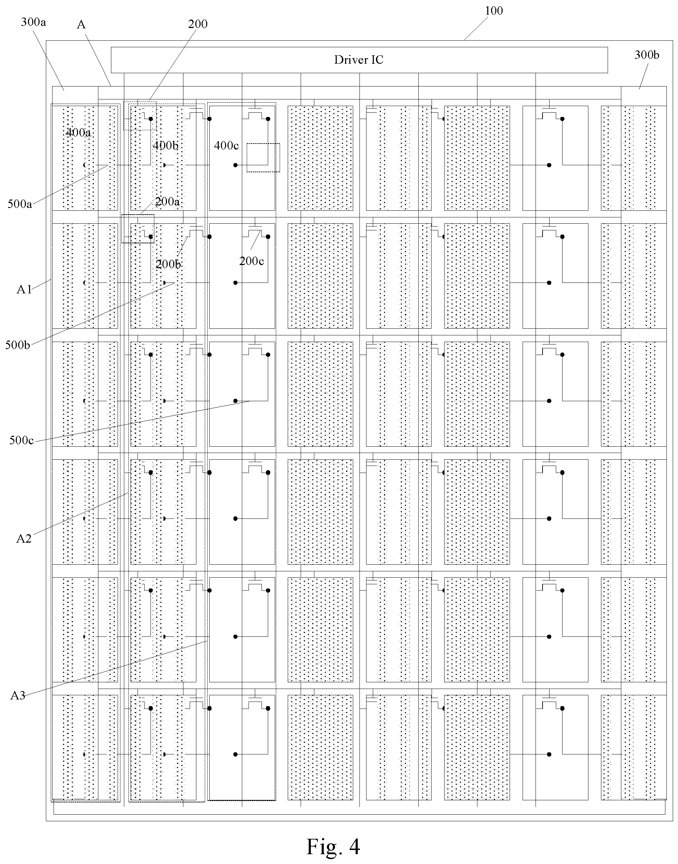

According to an embodiment of the present disclosure, a display panel is provided. As shown in Figs. 4-6, the display panel comprises a base substrate 100 comprising a display area A, a plurality of pixel driving circuits 200, a plurality of light-emitting units 400 and a plurality of connection lines 500, the plurality of pixel driving circuits 200, the plurality of light-emitting units 400 and the plurality of connection lines 500 are located on the base substrate 100 and in the display area A. At least one pixel driving circuit 200 of the plurality of pixel driving circuits is electrically connected with at least one light-emitting unit 400 of the plurality of light-emitting units via at least one connection line 500 of the plurality of connection lines.

In an embodiment, the light-emitting unit 400 is of top emission type, but the light-emitting unit is not limited to this embodiment, the light-emitting unit 400 is a bottom emission type light-emitting unit in other embodiments. The display panel further comprises a gate driving circuit 300. Further, an orthographic projection of the gate driving circuit 300 on the base substrate 100 does not overlap with an orthographic projection of the plurality of pixel driving circuits 200 on the base substrate 100. Besides, the orthographic projection of the gate driving circuit 300 on the base substrate 100 at least partially overlaps with an orthographic projection of the plurality of top emission type of light-emitting units 400 on the base substrate 100.

Specifically, in the above organic electroluminescence display panel provided by an embodiment of the present disclosure, the gate driving circuit 300 and the pixel driving circuits 200 are simultaneously disposed in the display area A of the base substrate 100, and also it is ensured that the orthographic projection of the gate driving circuit 300 on the base substrate 100 does not overlap with the orthographic projection of the pixel driving circuits 200 on the base substrate 100. That is, the switching transistors in the gate driving circuit 300 are not disposed inside the pixel driving circuit 200 as in Fig. 3, and thus will not occupy the wiring space of the pixel driving circuit 200. Therefore, it is ensured that both of the gate driving circuit 300 and the pixel driving circuit 200 have sufficient wiring spaces in the display area.

Meanwhile, in the above organic electroluminescence display panel provided by an embodiment of the present disclosure, a plurality of top emission type of light-emitting units 400, which is covering the pixel driving circuits 200 and the gate driving circuit 300, are further disposed in the display area A of the base substrate 100. In such a case, according to an embodiment of the present disclosure, the area occupied by each of the top emission type of light-emitting units is increased as compared with the conventional pixel unit (corresponding to the top emission type of light-emitting unit 400). Specifically, in the conventional approach, one of the top emission type of light-emitting units 400 only overlaps with one of the pixel driving circuits 200. That is, the conventional top emission type of light-emitting unit 400 is disposed in a region defined by the gate line and the data line. However, according to an embodiment of the present disclosure, the gate driving circuit 300 has an overlapping region with the top emission type of light-emitting units 400 in the display area A. That is, according to an embodiment of the present disclosure, the top emission type of light-emitting units 400 may span over the data lines, thereby ensuring that all circuits in the display area A are covered by the top emission type of light-emitting units 400. In this way, it is ensured that both of the gate driving circuit 300 and the pixel driving circuits 200 have sufficient wiring spaces in the display area A, thereby eliminating the need for arranging the gate driving circuit 300 at the frame, and thus realizing an ultra-narrow frame or even a frameless design.

According to a specific embodiment, in the above organic electroluminescence display panel provided by an embodiment of the present disclosure, each of the top emission type of light-emitting units 400 comprises generally an anode, a light-emitting layer, and a cathode that are sequentially stacked, wherein the anode is connected to a respective pixel driving circuit 200 via a corresponding connection line of the plurality of connection lines. In order to ensure light emission from the cathode side of each of the top emission type of light-emitting units 400, it is required that the cathode is made of light transmissive material. However, the anode may be generally fabricated by an opaque metal, or a reflective layer can be fabricated separately under a transparent anode. In addition, the top emission type of light-emitting unit 400 may further comprise a functional film layer, such as an electron transport layer, a hole transport layer, an electron blocking layer, and a hole blocking layer, and the present disclosure is not limited in this regard.

According to a specific embodiment, in the above organic electroluminescence display panel provided by an embodiment of the present disclosure, in order to ensure that light-emitting regions are distributed uniformly in the display area A, as shown in Figs. 4-6, anodes of each of the top emission type of light-emitting units 400 may be distributed uniformly in the display area A of the base substrate 100. That is, intervals between anodes of the top emission type of light-emitting units 400 keep the same.

According to a specific embodiment, in the above organic electroluminescence display panel provided by an embodiment of the present disclosure, in order to ensure that light-emitting regions are distributed uniformly in the display area A, as shown in Figs. 4-6, anodes of the top emission type of light-emitting units 400 can be configured to be the same in shape and size. Alternatively, when each of the top emission type of light-emitting units 400 is fabricated using a single color light-emitting layer, the light-emitting efficiency may be different depending on the material of the light-emitting layer in each of the top emission type of light-emitting units 400. Therefore, in a specific embodiment, it is also possible to set the area occupied by the light-emitting layer and the anode in each of the top emission type of light-emitting units 400 based on the light-emitting efficiency. That is, the area occupied by the top emission type of light-emitting unit 400 having high light-emitting efficiency is relatively small, and the area occupied by the top emission type of light-emitting unit 400 having low light-emitting efficiency is relatively large.

According to a specific embodiment, in the above organic electroluminescence display panel provided by an embodiment of the present disclosure, advantageously, as shown in Figs. 4-6, each of the top emission type of light-emitting units 400 is corresponding to a respective one of the pixel driving circuits 200, so as to drive the top emission type of light-emitting units 400 in a better way to emit light. That is, one pixel driving circuit 200 drives one of the top emission type of light-emitting units 400 to emit light. It is of course not excluded that one pixel driving circuit 200 drives a plurality of top emission type of light-emitting units 400 to emit light. In this case, since the area occupied by the top emission type of light-emitting unit 400 is increased, there may be a case where the top emission type of light-emitting unit 400 and its respective pixel driving circuit 200 do not directly overlap with each other. That is, for example, referring to Fig. 4, the top emission type of light-emitting units 400 in the leftmost column has an overlapping region only with the gate driving circuit 300. In view of above, as shown in Figs. 4-6, anodes of each of the top emission type of light-emitting units 400 need to be connected to their respective pixel driving circuits 200 by respective connection lines 500.

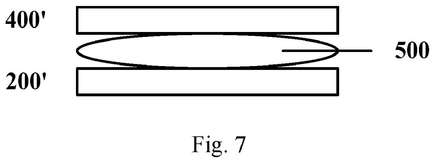

According to a specific embodiment, in the above organic electroluminescence display panel provided by an embodiment of the present disclosure, the connection lines 500 may be disposed in an existing conductive film layer, for example, disposed in the same layer as the gate lines, so as to reduce process steps. However, this will increase the complexity for wiring in the film. In view of above, advantageously, in the above organic electroluminescence display panel provided by an embodiment of the present disclosure, the connection lines 500 can be provided as a separate film layer. For example, referring to Fig. 7, which is a schematic diagram showing a hierarchical relationship between a connection line 500, a top emission type of light-emitting unit 400, and a pixel driving circuit 200 in an organic electroluminescence display panel according to an embodiment of the present disclosure. Specifically, the connection line 500 may be disposed between a first film layer 400' where the top emission type of light-emitting unit 400 is located and a second film layer 200' where the pixel driving circuit 200 is located. That is, the plurality of connection lines 500 are located on a side of the plurality of pixel driving circuits 200 facing away the base substrate, and the plurality of light-emitting units 400 are located on a side of the plurality of connection lines 500 facing away the base substrate. This means that in the above embodiment, the film layers to be patterned in the fabricating process of the organic electroluminescence display panel are respectively: active layer-*gate insulating layer-*gate metal layer-*interlayer insulating layer→source-drain metal layer-*planarization layer→anode→pixel defining layer-*spacer layer. In contrast, for the organic electroluminescence display panel provided by embodiments of the present disclosure, two additional film layers are needed in the fabricating process. That is, the film layers will change to be respectively: active layer-*gate insulating layer→gate metal layer-*interlayer insulating layer→source-drain metal layer-*insulating layer→connection line layer-*planarization layer→anode→pixel defining layer-*spacer layer.

Therefore, in some embodiments, the plurality of pixel driving circuits comprise a source-drain metal layer on the base substrate, the display panel further comprise an insulating layer on the source-drain metal layer and a connection line layer on the insulating layer, the connection line layer comprises the plurality of connection lines. Further, the display panel comprises a planarization layer, each light-emitting unit of the plurality of light-emitting units comprises an anode, a light-emitting layer and a cathode sequentially stacked, the planarization layer is between the source-drain metal layer and a layer of the anode, and the connection line layer is between the insulating layer and the planarization layer. According to a specific embodiment, in the above organic electroluminescence display panel provided by an embodiment of the present disclosure, the specific position for the gate driving circuit 300 in the display area A of the base substrate 100 is not limited, which may be determined based on the actual size of the display panel. For example, as shown in Fig. 4, the gate driving circuit 300 may be disposed at an edge of the display area A of the base substrate 100. Moreover, in the above organic electroluminescence display panel provided by an embodiment of the present disclosure, as shown in Fig. 4, the gate driving circuit 300 may comprise two gate sub-driving circuits, which are respectively disposed at two opposite edges of the display area of the base substrate 100, so as to achieve bilateral driving. In this way, problems such as signal delay in a large-sized panel can be alleviated. Of course, alternatively, the gate driving circuit 300 may be disposed only at any edge of the display area A.

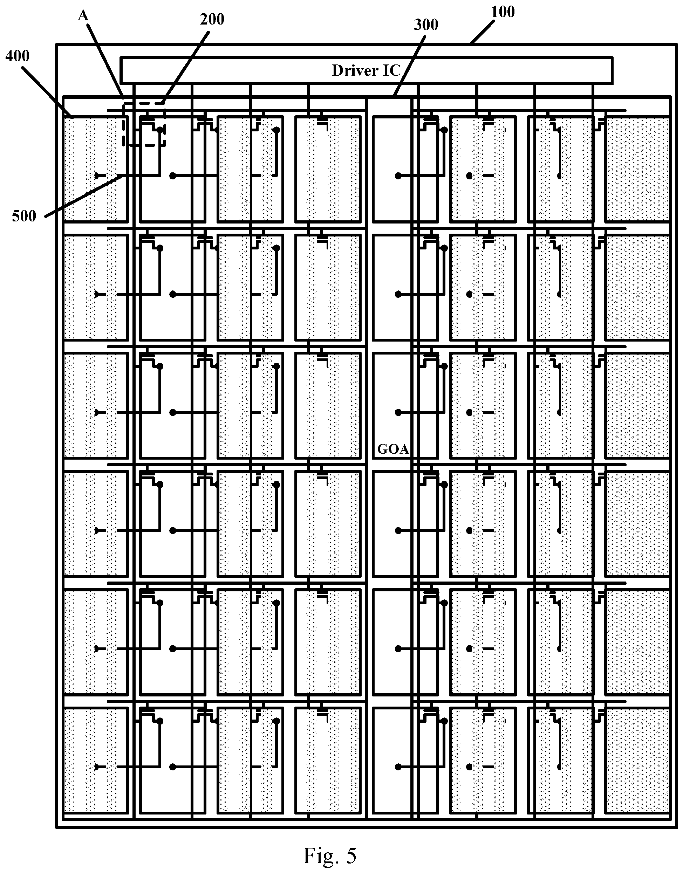

According to a specific embodiment, in the above organic electroluminescence display panel provided by an embodiment of the present disclosure, as shown in Fig. 5, the gate driving circuit 300 may be disposed at a position between two adjacent pixel driving circuits 200. For example, in Fig. 5, the gate driving circuit 300 is disposed at an intermediate position of the display area A. Therefore, driving signals can be supplied at the same time to the gate lines at both sides, thereby contributing to a reduction of signal delay.

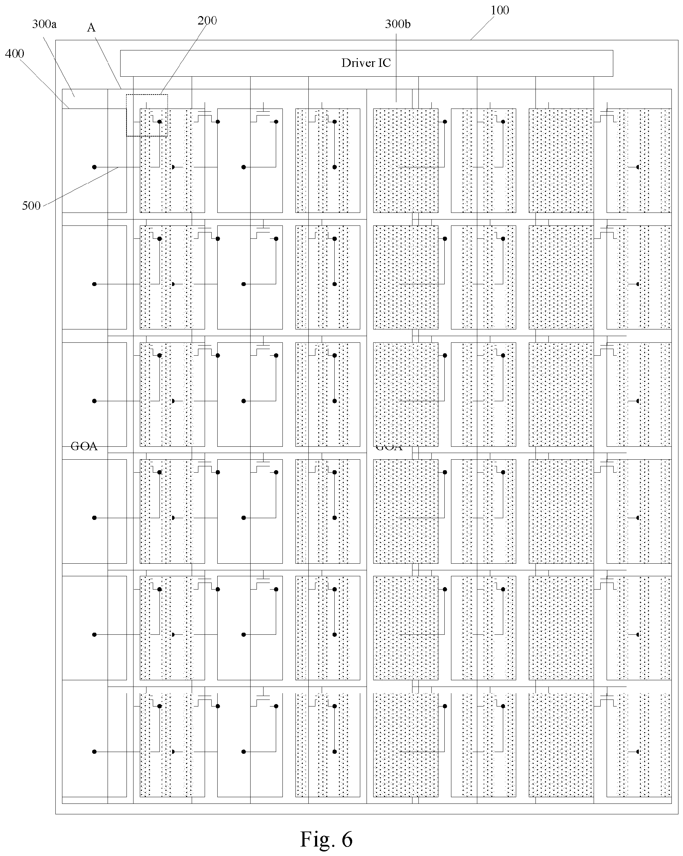

Obviously, the above content is merely for illustrating how to dispose the gate driving circuit 300 in the display area A of the above organic electroluminescence display panel provided by embodiments of the present disclosure, and the present disclosure is not limited thereto. For example, as shown in Fig. 6, a plurality of gate sub-driving circuits may be simultaneously disposed at edge and intermediate position of the display area A, and they constitute together the gate driving circuit 300. Of course, the present disclosure is in no way limited in this respect.

In some embodiment, each pixel driving circuit of the plurality of pixel driving circuits is electrically connected with at least two light-emitting units of the plurality of light-emitting units via at least two connection lines of the plurality of connection lines. Alternatively, in other embodiments, the plurality of pixel driving circuits are electrically connected in one-to-one correspondence with the plurality of light-emitting units via the plurality of connection lines. For example, as shown in figure 4, each pixel driving circuit 200 is electrically connected with a corresponding light-emitting unit via a corresponding connection line of the plurality of connection lines.

Continue referring to figure 4, the display area comprises a first display subarea A1 and a second display subarea A2 located on at least one side of the first display subarea A1. The plurality of light-emitting units comprise multiple first light-emitting units 400a within the first display subarea A1. The plurality of pixel driving circuits comprise multiple first pixel driving circuits 200a within the second display subarea A2, the plurality of connection lines comprise multiple first connection lines 500a. The multiple first pixel driving circuits 200a are electrically connected with the multiple first light-emitting units 400a respectively via the multiple first connection lines 500a, and orthogonal projections of the multiple first pixel driving circuits on the base substrate 100 do not overlap with orthogonal projections of the multiple first light-emitting units on the base substrate.

As shown in figure 4, the plurality of light-emitting units comprise multiple second light-emitting units 400b within the second display subarea A2, the plurality of pixel driving circuits comprise multiple second pixel driving circuits 200b within the second display subarea A2, the plurality of connection lines comprise multiple second connection lines 500b. The multiple second pixel driving circuits 200b are electrically connected with the multiple second light-emitting units 400b respectively via the second multiple second connection lines 500b. An orthographic projection of at least one second pixel driving circuit 200b of the multiple second pixel driving circuits on the base substrate 100 partially overlaps with an orthographic projection of at least one second light-emitting unit 400b of the multiple second light-emitting units on the base substrate 100.

In some embodiments, the display area further comprises a third display subarea A3 located on at least one side of the second display subarea A2, the plurality of light-emitting units comprise multiple third light-emitting units 400c within the third display subarea A3, the plurality of pixel driving circuits comprise multiple third pixel driving circuits 200c within the third display subarea A3, the plurality of connection lines comprise multiple third connection lines 500c. The multiple third pixel driving circuits 200c are electrically connected with the multiple third light-emitting units 400c respectively via the multiple third connection lines 500c, an orthographic projection of at least one third light-emitting unit 400c of the multiple third light-emitting units on the base substrate 100 covers an orthographic projection of at least one third connection line 500c of the multiple third connection lines on the base substrate.

As previously mentioned, the display panel further comprises a gate driving circuit on the base substrate. In some embodiments, as shown in figure 4, the gate driving circuit comprises a first gate sub-driving circuit 300a and a second gate sub-driving circuit 300b, the first gate sub-driving circuit 300a and the second gate sub-driving circuit 300b respectively extend along a first edge and a second edge of the display area opposite to each other, the first gate sub-driving circuit 300a is located within the first display subarea A1. Further, referring to figure 4, the first gate sub-driving circuit 300a and the second gate sub-driving circuit 300b are separated from each other by at least the second display subarea A2. An orthogonal projection of the first gate sub-driving circuit 300a and the second gate sub-driving circuit 300b on the base substrate does not overlap with an orthogonal projection of the plurality of pixel driving circuits 200 on the base substrate, an orthogonal projection of the first gate sub-driving circuit 300a on the base substrate partially overlaps an orthogonal projection of at least a portion of the multiple light-emitting units 400a on the base substrate.

Alternatively, referring to figure 6, in some embodiments, the gate driving circuit comprises a first gate sub-driving circuit 300a and a second gate sub-driving circuit 300b, the first gate sub-driving circuit 300a is located within the first display subarea A1 and extends along an edge of the first display subarea, the second gate sub-driving circuit 300b is between two column of pixel driving circuits 200 of the plurality of pixel driving circuits.

Based on the same concept, embodiments of the present disclosure also provide a display device, comprising the organic electroluminescence display panel according to any of the above embodiments of the present disclosure. The display device can be any products or components having a display function, such as a mobile phone, a tablet computer, a television set, a display, a notebook computer, a digital photo frame, a navigator, and the like. For specific implementations of the display device, reference may be made to the embodiments of the above organic electroluminescence display panel, and the repeated description is omitted herein.

The display panel and the display device mentioned herein are both capable of displaying images. However, as compared to the display panel, the display device may comprise additional elements that is not essential to the displaying function, which may protect the display panel and advantageous to operating the display panel. An example of the additional elements includes but are not limited to a frame. In other words, the display panel may be considered as a portion of the display device.

Based on the same concept, embodiments of the present disclosure also provide a fabricating method for the above organic electroluminescence display panel. The fabricating method comprises the steps of: fabricating a gate driving circuit and a plurality of pixel driving circuits in a display area of a base substrate, wherein an orthogonal projection of the gate driving circuit on the base substrate does not overlap with an orthogonal projection of the plurality of pixel driving circuits on the base substrate; and fabricating further a plurality of top emission type of light-emitting units in the display area of the base substrate, wherein the plurality of top emission type of light-emitting units at least partially cover the plurality of pixel driving circuits and the gate driving circuit, and an orthographic projection of the gate driving circuit on the base substrate at least partially overlaps with an orthographic projection of the plurality of top emission type of light-emitting units on the base substrate.

According to a specific embodiment, the above fabricating method provided by embodiments of the present disclosure may also comprise the following optional steps: after fabricating the gate driving circuit and the plurality of pixel driving circuits in the display area of the base substrate, and before fabricating further the plurality of top emission type of light-emitting units in the display area of the base substrate, fabricating connection lines for connecting an anode of each of the top emission type of light-emitting units to a respective pixel driving circuit.

For example, in the fabricating method for the organic electroluminescence display panel provided by embodiments of the present disclosure, the film layers to be patterned are respectively: active layer→gate insulating layer-*gate metal layer-*interlayer insulating layer→source→drain metal layer →insulat-ing layer→connection line layer-*planarization layer→anode→pixel defining layer-*spacer layer. The above is merely an example in which a driving circuit is constituted by a top gate transistor. Of course, according to a specific embodiment, the driving circuit can also be fabricated by a bottom gate transistor, which is not limited herein.

Embodiments of the present disclosure provide an organic electroluminescence display panel, a fabricating method thereof, and a display device. Specifically, in the above organic electroluminescence display panel, the gate driving circuit and the pixel driving circuits are simultaneously disposed in the display area of the base substrate. Further, it is also ensured that the orthographic projection of the gate driving circuit on the base substrate does not overlap with the orthographic projection of the pixel driving circuits on the base substrate, thereby providing sufficient wiring spaces for both of the gate driving circuit and the pixel driving circuits in the display area. Further, a plurality of top emission type of light-emitting units at least partially covering the pixel driving circuits and the gate driving circuit are further provided in the display area of the base substrate. Therefore, the area occupied by each of the top emission type of light-emitting units is increased. Those skilled in the art should readily contemplate that in a conventional display panel, one of the top emission type of light-emitting units overlaps only with one of the pixel driving circuits. However, by contrast, in embodiments of the present disclosure, the gate driving circuit in the display area has an overlapping region with the top emission type of light-emitting units, thereby ensuring that all circuits in the display area are covered by the top emission type of light-emitting units. In this way, it is ensured that there are sufficient wiring spaces for the gate driving circuit and the pixel driving circuits in the display area, thereby eliminating the need to provide the gate driving circuit at the frame, and achieving an ultra-narrow frame or even a frameless design.

In all the descriptions herein, the expression of "orthographic projection of A on a base substrate" refers to a projection of A onto the base substrate in a direction perpendicular to the base substrate, which should be readily appreciated by those skilled in the art.

Apparently, the person skilled in the art may make various alterations and variations to the present disclosure without departing the spirit and scope of the present disclosure. As such, provided that these modifications and variations of the present disclosure pertain to the scope of the claims of the present disclosure and their equivalents, the present disclosure is intended to embrace these alterations and variations.

## Claims

1. A display panel, **characterized in that**, the display panel comprises:
a base substrate comprising a display area;
a plurality of pixel driving circuits, a plurality of light-emitting units and a plurality of connection lines, the plurality of pixel driving circuits, the plurality of light-emitting units and the plurality of connection lines being located on the base substrate and in the display area,
wherein at least one pixel driving circuit of the plurality of pixel driving circuits is electrically connected with at least one light-emitting unit of the plurality of light-emitting units via at least one connection line of the plurality of connection lines.

2. The display panel according to claim 1, **characterized in that**, one pixel driving circuit of the plurality of pixel driving circuits is electrically connected with at least two light-emitting units of the plurality of light-emitting units via at least two connection lines of the plurality of connection lines.

3. The display panel according to claim 1, **characterized in that**, the plurality of pixel driving circuits are electrically connected in one-to-one correspondence with the plurality of light-emitting units via the plurality of connection lines.

4. The display panel according to claim 1, **characterized in that**, the display area comprises a first display subarea and a second display subarea located on at least one side of the first display subarea,
wherein the plurality of light-emitting units comprise multiple first light-emitting units within the first display subarea, the plurality of pixel driving circuits comprise multiple first pixel driving circuits within the second display subarea, the plurality of connection lines comprise multiple first connection lines,
wherein the multiple first pixel driving circuits are electrically connected in one-to-one correspondence with the multiple first light-emitting units via the multiple first connection lines, and orthogonal projections of the multiple first pixel driving circuits on the base substrate do not overlap with orthogonal projections of the multiple first light-emitting units on the base substrate.

5. The display panel according to claim 4, **characterized in that**, the plurality of light-emitting units comprise multiple second light-emitting units within the second display subarea, the plurality of pixel driving circuits comprise multiple second pixel driving circuits within the second display subarea, the plurality of connection lines comprise multiple second connection lines,
wherein the multiple second pixel driving circuits are electrically connected in one-to-one correspondence with the multiple second light-emitting units via the multiple second connection lines, an orthographic projection of at least one second pixel driving circuit of the multiple second pixel driving circuits on the base substrate partially overlaps with an orthographic projection of at least one second light-emitting unit of the multiple second light-emitting units on the base substrate.

6. The display panel according to claim 5, **characterized in that**, the display area further comprises a third display subarea located on at least one side of the second display subarea,
wherein the plurality of light-emitting units comprise multiple third light-emitting units within the third display subarea, the plurality of pixel driving circuits comprise multiple third pixel driving circuits within the third display subarea, the plurality of connection lines comprise multiple third connection lines,
wherein the multiple third pixel driving circuits are electrically connected in one-to-one correspondence with the multiple third light-emitting units via the multiple third connection lines, an orthographic projection of at least one third light-emitting unit of the multiple third light-emitting units on the base substrate covers an orthographic projection of at least one third connection line of the multiple third connection lines on the base substrate.

7. The display panel according to any one of claims 1 to 6, **characterized in that**, the plurality of connection lines are located on a side of the plurality of pixel driving circuits facing away the base substrate, and the plurality of light-emitting units are located on a side of the plurality of connection lines facing away the base substrate.

8. The display panel according to claim 7, **characterized in that**, each light-emitting unit of the plurality of light-emitting units comprises an anode, a light-emitting layer and a cathode sequentially stacked, wherein the anode is connected to a corresponding pixel driving circuit of the plurality of pixel driving circuits via a corresponding connection line of the plurality of connection lines.

9. The display panel according to any one of claims 1 to 6 and 8, **characterized in that**, the plurality of pixel driving circuits comprise a source-drain metal layer on the base substrate, the display panel further comprise an insulating layer on the source-drain metal layer and a connection line layer on the insulating layer, wherein the connection line layer comprises the plurality of connection lines.

10. The display panel according to claim 9, **characterized in that**, the display panel further comprises a planarization layer, each light-emitting unit of the plurality of light-emitting units comprises an anode, a light-emitting layer and a cathode sequentially stacked, wherein the planarization layer is between the source-drain metal layer and a layer of the anode, and the connection line layer is between the insulating layer and the planarization layer.

11. The display panel according to claim 5 or 6, **characterized in that**, the display panel further comprises a gate driving circuit on the base substrate, the gate driving circuit comprises a first gate sub-driving circuit and a second gate sub-driving circuit, the first gate sub-driving circuit and the second gate sub-driving circuit respectively extend along a first edge and a second edge of the display area opposite to each other, wherein the first gate sub-driving circuit is located within the first display subarea.

12. The display panel according to claim 11, **characterized in that**, the first gate sub-driving circuit and the second gate sub-driving circuit are separated from each other by at least the second display subarea.

13. The display panel according to claim 11, **characterized in that**, orthogonal projections of the first gate sub-driving circuit and the second gate sub-driving circuit on the base substrate do not overlap with orthogonal projections of the plurality of pixel driving circuits on the base substrate, wherein an orthogonal projection of the first gate sub-driving circuit on the base substrate partially overlaps orthogonal projections of at least some first light-emitting units of the multiple first light-emitting units on the base substrate.

14. The display panel according to claims 5 or 6, **characterized in that**, the display panel further comprises a gate driving circuit on the base substrate, the gate driving circuit comprises a first gate sub-driving circuit and a second gate sub-driving circuit, wherein the first gate sub-driving circuit is located within the first display subarea and extends along an edge of the first display subarea, the second gate sub-driving circuit is between two adjacent columns of pixel driving circuits of the plurality of pixel driving circuits.

15. A display device, **characterized in that**, the display device comprises the display panel according to any one of claim 1 to 14.
